(19) Europäisches Patentamt
European Patent Office
Office européen des brevets

(11) EP 2 407 576 A1

(12) EUROPEAN PATENT APPLICATION
published in accordance with Art. 153(4) EPC

(43) Date of publication:
**18.01.2012 Bulletin 2012/03**

(21) Application number: **10750648.7**

(22) Date of filing: **15.02.2010**

(51) Int Cl.:
***C23C 16/44*** (2006.01) ***C23C 16/52*** (2006.01)
***H01L 21/285*** (2006.01)

(86) International application number:
**PCT/JP2010/052199**

(87) International publication number:
**WO 2010/103893 (16.09.2010 Gazette 2010/37)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **13.03.2009 JP 2009060883**

(71) Applicant: **Adeka Corporation**
**Tokyo 116-8554 (JP)**

(72) Inventors:
- **SHIRATORI, Tsubasa**
  **Tokyo 116-8554 (JP)**
- **WATANABE, Tsuyoshi**
  **Tokyo 116-8554 (JP)**
- **ENOMOTO, Yoshiji**
  **Tokyo 116-8554 (JP)**

(74) Representative: **Forstmeyer, Dietmar et al**
**BOETERS & LIECK**
**Oberanger 32**
**80331 München (DE)**

(54) **PROCESS FOR REMOVING RESIDUAL WATER MOLECULES IN PROCESS FOR PRODUCING METALLIC THIN FILM, AND PURGE SOLVENT**

(57) The present process for removing residual water molecules is suitably used in a metallic thin film production method of forming a metallic thin film on a substrate. The residual-water-molecule removal process involves removing residual water molecules using a gas generated by vaporizing a purge solvent. Preferably, the purge solvent is an organic solvent or an organic solvent composition having a water content at the azeotropic composition of at least 20% by mass. With the present residual-water-molecule removal process, water molecules remaining in the system can be removed efficiently in the production of metallic thin films by the ALD method or the like, and thus, the film-formation time can be shortened and metallic thin films can be produced efficiently.

[Fig. 1]

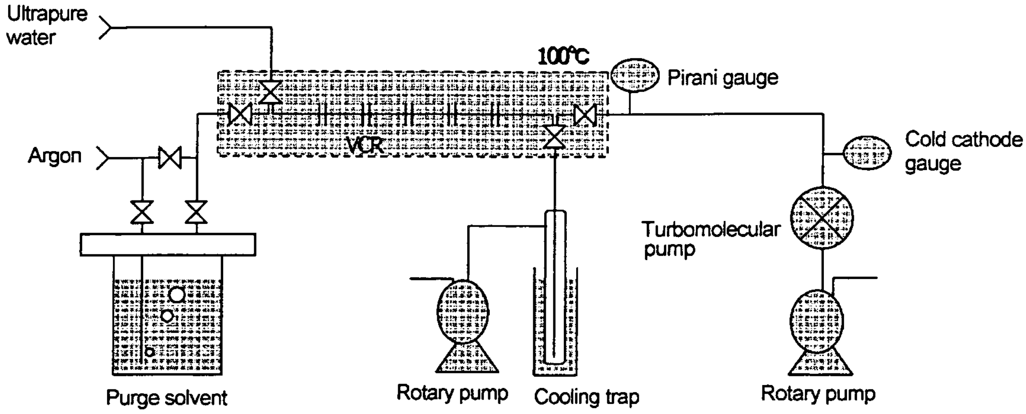


EP 2 407 576 A1

## Description

### Technical Field

The present invention relates to a process which is suitably used in a metallic-thin-film production method and which is for removing water molecules remaining in the system through the use of a gas generated by vaporizing a purge solvent, and a purge solvent used for the aforementioned process.

### Background Art

Metal-oxide thin films are used for electronic components in electronic parts, such as high-dielectric capacitors, ferroelectric capacitors, gate films, barrier films, and gate insulating films, as well as for optical components in optical communication devices, such as light guides, optical switches, and optical amplifiers.

Methods for producing the aforementioned thin films include, for example, MOD methods, such as the thermal decomposition method and the sol-gel method, the CVD method, and the ALD method. Among these, production methods which employ vaporized precursors, such as the CVD and ALD methods, are considered most suitable because of the various advantages thereof, such as excellent composition controllability and step coverability, suitability for mass production, and capability of hybrid integration.

As an example of producing thin films containing titanium, zirconium, or hafnium, Patent Literature 1 discloses the production of thin films through the ALD method using a β-diketone complex as the precursor and oxygen-containing radicals, such as water vapor, oxygen, hydrogen peroxide, or peracetic acid, as the reactive gas. Patent Literature 2 discloses a method of forming thin films of compounds, such as BST, STO, (Ti, A1)N, and Ta-Ti-O, in batches using the ALD method. Patent Literature 3 and 4 discloses the production of metal-oxide thin films using metallic amide compounds. Patent Literature 5 discloses a method of producing conductive structures, the method involving first forming a metallic barrier film using the ALD method or otherwise, and then purifying the metallic barrier film using argon gas and $TiCl_4$ gas.

The ALD method usually forms films in units of atomic layers by repeating, several times, the sequence of supplying a reactive gas such as $H_2O$ $NH_3$, $O_2$, or $O_3$, purging by vacuum evacuation, supplying a metallic material gas, purging by vacuum evacuation, and again supplying a reactive gas such as $H_2O$ $NH_3$, $O_2$, or $O_3$. Therefore, the ALD method basically requires a prolonged time for film formation and thus tends to be unfit for mass production. Particularly in cases of using several kinds of metallic material gases, the composition control requires the use of a multi-component system in order to inhibit mutual reaction between the metallic material gases, in which case the purge time achieved by vacuum evacuation etc. becomes extremely long.

An example of the aforementioned reactive gas is water vapor: water vapor is highly reactive with thin-film precursors and contains minimal amounts of impurities such as carbon residue, and is thus preferable as an oxidizer used in the preparation of high-dielectric films. However, it is difficult to efficiently remove the residual water molecules remaining in the system by heat vacuum evacuation or purging with inert gas, and the removal of water molecules becomes rate-determining, thus making the purge time extremely long.

### Citation List

#### Patent Literature

Patent Document 1: US 2002/042165 A1
Patent Document 2: JP-A-2004-23043
Patent Document 3: US 2006/046421 A1
Patent Document 4: JP-A-2006-182709
Patent Document 5: US 2004/248397 A1

### Summary of Invention

#### Technical Problem

An object to be achieved by the present invention is to efficiently remove residual water molecules remaining in the system and shorten the purge time in the production of metallic thin films by the ALD method or the like.

## Solution to Problem

Through diligent research, Inventors have found that a purge solvent composed of specific components can achieve the aforementioned object, thus arriving at the present invention.
Specifically, the invention provides a process for removing residual water molecules, the process being used in a metallic thin film production method of forming a metallic thin film on a substrate, the process involving removing residual water molecules using a gas generated by vaporizing a purge solvent.
The invention also provides a purge solvent that can preferably be used in the aforementioned process, the purge solvent being an organic solvent or an organic solvent composition having a water content at the azeotropic composition of at least 20% by mass.

## Advantageous Effects of Invention

With the present invention, water molecules remaining in the system can be removed efficiently in the production of metallic thin films by the ALD method or the like, and thus, the film-formation time can be shortened and metallic thin films can be produced efficiently.

## Brief Description of Drawings

[Fig. 1] Fig. 1 is a schematic diagram illustrating a device used in the Examples.

## Description of Embodiments

The residual-water-molecule removal process according to the present invention is suitably used in a metallic-thin-film formation method which involves a step of using water or water vapor or a step in which water is produced as a reaction product. The present process can be used in various metallic-thin-film production methods, such as MOD methods including the thermal decomposition method and the sol-gel method and chemical vapor deposition techniques including the CVD method and the ALD method, and can suitably be used in the CVD method and the ALD method which use water vapor as an oxidizer.
An example of the ALD method including the present process will be described below.
In the production of a metallic thin film according to a general ALD method, the procedure of supplying of a thin-film forming material (also referred to hereinafter simply as "material") onto a deposition site and then supplying a reactive gas is regarded as a single cycle, and the material and the reactive gas are supplied alternately to deposit a desired thin-film molecular layer stepwise. The thin-film forming material contains a metal compound (described further below) as a precursor. Where necessary, a plurality of kinds of materials, each containing a different precursor, may be used in combination. When using several materials in combination, the materials are supplied sequentially and independent of one another onto the deposition site and a reactive gas is supplied at the end, and this procedure is regarded as one cycle.
In cases where the process of the present invention is applied to the aforementioned process of producing a metallic thin film according to the ALD method, a single cycle will include: (1) a step of supplying a substrate with vapor generated by vaporizing the material at high temperatures, to make the vaporized material be adsorbed on the substrate; (2) a step of supplying the substrate with water vapor, which serves as the reactive gas, to make the water vapor react with the material and grow and deposit a thin film on the substrate; and (3) a step of removing the water molecules inside the reaction system by supplying the reaction system with a gas generated by vaporizing a purge solvent. A step of removing the unreacted material gas, the reactive gas, or the purge-solvent gas by purging with an inert gas and/or by evacuation at reduced pressure may be introduced optionally in each cycle between steps (1) and (2), between steps (2) and (3), and/or between steps (3) and (1). The methods of transporting and supplying the material, the deposition method, the production conditions, the production device, etc., are not particularly limited, and generally known conditions and methods may be employed. The ALD method is **characterized in that** a thin, uniform thin film with good properties can be produced, and the film-formation mechanism thereof helps to keep the thin film deposition temperature low, allowing the ALD method to be used in various applications without being dependant on factors such as the heat resistance of the substrate and the diffusibility of elements into the substrate. ALD can also be used in combination with heat, light, or plasmas.
In the aforementioned example, "(3) the step of removing the water molecules inside the reaction system by supplying the reaction system with a gas generated by vaporizing a purge solvent" is the water-molecule removal step according to the process of the present invention. This is described in detail. The reaction system prior to step (3) contains

water molecules that remain from step (2). Even if a step of removing water vapor by inert-gas purging and/or by reduced-pressure evacuation is conducted after step (2), the water molecules in the reaction system cannot be completely removed and thus remain in the system. Particularly, the water molecules are likely to remain on the wall surfaces and inside the pipelines. By performing step (3) to supply the vaporized-purge-solvent gas into the system containing residual water molecules, the gas flows through the system to purge the water molecules therefrom. Through this step, the water molecules remaining in the system are discharged therefrom along with the vaporized-purge-solvent gas, and the water molecules are thus removed. From the standpoint of removing water molecules more efficiently, it is preferable to introduce a step of removing the purge-solvent gas by inert-gas purging and/or by reduced-pressure evacuation between step (3) and step (1) of the next cycle.

In step (3), it is only necessary that the gas inside the system is replaced with the vaporized-purge-solvent gas, and the method of supplying the gas, the conditions therefor, etc., are not particularly limited. For example, the vaporized-purge-solvent gas may be supplied in the same way as general inert-gas purging methods. It is preferable to keep the temperature inside the system within the range of 80 to 120°C from the standpoint of efficient water-molecule removal. Because the system is already heated in steps (1) and (2) in the ALD method, the aforementioned temperature range is often achieved without any special temperature control.

Other than for the removal of residual water molecules in a reaction system for depositing thin films, the process of the present invention can suitably be used likewise for the removal of residual water molecules in pipelines through which water vapor has been circulated as a reactive gas. Also, the process can suitably be used likewise in thin-film production methods other than the ALD method.

The purge solvent can be vaporized by various means, such as heat, carrier gas, or reduced pressure. In cases of achieving vaporization by heat, the heating temperature can be chosen as appropriate depending on the kind of the purge solvent and preferably ranges from 50 to 200°C. Vaporization using a carrier gas can be achieved by bubbling the purge solvent with the carrier gas. The carrier gas used for bubbling the purge solvent can be supplied into the system without being removed. Examples of the carrier gas include nitrogen and rare gases (helium, neon, argon, and xenon). The carrier gas flow rate is preferably 0.1 to 1.5 slm. In cases of achieving vaporization by reduced pressure, the pressure can be chosen as appropriate depending on the kind of the purge solvent and preferably ranges from 1 to 10 Pa.

An organic solvent or an organic solvent composition can be used for the purge solvent. Generally known organic solvents can be used as the organic solvent without particular limitation, with examples including: ketone solvents such as methyl ethyl ketone, methyl amyl ketone, diethyl ketone, acetone, methyl isopropyl ketone, methyl isobutyl ketone, and cyclohexanone; ether solvents such as ethyl ether, propyl ether, dioxane, tetrahydrofuran, 1,2-dimethoxyethane, 1,2-diethoxyethane, and dipropylene glycol dimethyl ether; ester solvents such as methyl acetate, ethyl acetate, n-propyl acetate, isopropyl acetate, and n-butyl acetate; cellosolve solvents such as ethylene glycol monomethyl ether, ethylene glycol monoethyl ether, and propylene glycol monomethyl ether acetate; alcoholic solvents such as methanol, ethanol, iso- or 1-propanol, iso- or 1-butanol, and 1-pentanol; aromatic hydrocarbonic solvents such as benzene, toluene, and xylene; aliphatic hydrocarbonic solvents such as hexane, heptane, octane, and cyclohexane; terpene-based hydrocarbon oils such as turpentine, D-limonene, and pinene; paraffin solvents such as mineral spirit, Swasol #310 (Cosmo Matsuyama Oil Co., Ltd.), and Solvesso #100 (Exxon Chemical Company); halogenated aliphatic hydrocarbonic solvents such as carbon tetrachloride, chloroform, trichloroethylene, and methylene chloride; halogenated aromatic hydrocarbonic solvents such as chlorobenzene; and other compounds such as Carbitols, aniline, triethylamine, pyridine, acetic acid, acetonitrile, carbon disulfide, tetrahydrofuran, N,N-dimethylformamide, and N-methylpyrrolidone. Two or more of these organic solvents may be mixed and used as an organic solvent composition. Of the aforementioned organic solvents and organic solvent compositions, preferable are solvents/compositions that vaporize readily, that have high flowability, that do not decompose at temperatures as high as 300°C or above, and that can readily form an azeotrope with water. Particularly, an organic solvent or an organic solvent composition having a water content at the azeotropic composition of at least 20% by mass is preferable because of good dehydration capabilities. It is even more preferable if the water content at the azeotropic composition is 30% by mass or above. There is no particular upper limit to the water content at the azeotropic composition, but generally it is around 99.9% by mass at the most.

Alcoholic solvents are preferable as the aforementioned organic solvent, and among various alcoholic solvents, 1-butanol and 1-pentanol are preferable because the water content at the azeotropic composition is at least 20% by mass and they have good dehydration capabilities. As for the aforementioned organic solvent composition, it is preferable to use a composition containing the aforementioned alcoholic solvent and also a hydrocarbonic solvent, particularly, a hydrocarbonic solvent which forms an azeotrope with the alcoholic solvent in which the alcoholic solvent content at the azeotropic composition is at least 20% by mass-specifically toluene or xylene-because it is possible to prevent the alcoholic solvent from remaining in the pipelines or on the wall surfaces due to adsorption.

In cases of using an organic solvent composition containing an alcoholic solvent, it is preferable that the alcoholic solvent content in the organic solvent composition is from 1% to 99.9% by mass. In cases of using an organic solvent composition composed of an alcoholic solvent and a hydrocarbonic solvent, it is preferable that the alcoholic solvent

content in the organic solvent composition is 20% to 50% by mass and the hydrocarbonic solvent content is 50% to 80% by mass. Examples of the organic solvent composition in which the water content at the azeotropic composition is at least 20% by mass include the following compositions.

Composition 1:

Ketone solvent: 20% to 40% by mass
Hydrocarbonic solvent: 60% to 80% by mass

Composition 2:

Alcoholic solvent: 20% to 50% by mass
Ether solvent: 1 % to 20% by mass
Hydrocarbonic solvent: 30% to 79% by mass

Among the aforementioned organic solvents, some ester solvents form an azeotrope with water, but ester solvents are not preferable because there is a possibility that the residual solvent may react with the material or may cause thermal decomposition.
The amount of water in the purge solvent is preferably 10 ppm or less, more preferably 1 ppm or less. The purge solvent should contain the smallest amount possible of metal impurities, halogen impurities such as chlorine, and organic impurities. The amount of metal impurities is preferably 100 ppb or less, more preferably 10 ppb or less, for each metal element. The total amount of metal impurities is preferably 1 ppm or less, more preferably 100 ppb or less. Especially in cases of using metal oxides, complex metal oxides of silicon, nitrides, or nitride oxides of silicon for gate insulating films, gate films, and barrier layers in LSIs, it is necessary to reduce the content of alkali metal elements, alkaline-earth metal elements, and congeneric elements (titanium, zirconium, or hafnium), which affect the electrical properties of the thin films produced. The amount of halogen impurities is preferably 100 ppm or less, more preferably 10 ppm or less, even more preferably 1 ppm or less. The total amount of organic impurities is preferably 500 ppm or less, more preferably 50 ppm or less, even more preferably 10 ppm or less.
To inhibit or prevent the produced thin film from being contaminated by particles, it is preferable that the purge solvent contains at most 100 particles larger than 0.3 μm, more preferably at most 1000 particles larger than 0.2 μm per 1 mL of the liquid phase, and more preferably at most 100 particles larger than 0.2 μm per 1 mL of the liquid phase, the number of particles being found by subjecting the liquid phase to particle measurement using a light-scattering liquid-borne particle detector.
The thin-film forming material used in the CVD method or the ALD method including the process of the present invention contains a metal compound as a precursor for the thin film. The thin-film forming material may be the metal compound itself or may take the form of a solution prepared by dissolving the metal compound in an organic solvent. The form of the material is chosen as appropriate depending on, for example, how the material is transported and supplied in the thin-film production method in which the material is used.
The concentration of the aforementioned material is not particularly limited; the concentration can be at any level as long as a stable solution can be supplied and can be chosen as appropriate depending on such factors as the amount of material supplied and the film-formation rate during the thin-film production. In cases where the material is made into a solution, the concentration of the metal compound is preferably from 0.05 to 0.5 mol/L, because concentrations below 0.05 mol/L may impair the stability in supplying the metal source and reduce the film-formation rate, whereas concentrations above 0.5 mol/L may impair the flowability of the material and cause problems such as precipitation.
Also, there is no particular limitation to the metal atoms contained in the metal compound, and the metal atoms can be chosen freely so that desired oxides or complex oxides can be formed.
Examples of the aforementioned metal atoms include: Group 1 elements including lithium, sodium, potassium, rubidium, and cesium; Group 2 elements including beryllium, magnesium, calcium, strontium, and barium; Group 3 elements including scandium, yttrium, lanthanoid elements (lanthanum, cerium, praseodymium, neodymium, promethium, samarium, europium, gadolinium, terbium, dysprosium, holmium, erbium, thulium, ytterbium, and lutetium), and actinoid elements; Group 4 elements including titanium, zirconium, and hafnium; Group 5 elements including vanadium, niobium, and tantalum; Group 6 elements including chromium, molybdenum, and tungsten; Group 7 elements including manganese, technetium, and rhenium; Group 8 elements including iron, ruthenium, and osmium; Group 9 elements including cobalt, rhodium, and iridium; Group 10 elements including nickel, palladium, and platinum; Group 11 elements including copper, silver, and gold; Group 12 elements including zinc, cadmium, and mercury; Group 13 elements including boron, aluminum, gallium, indium, and thallium; Group 14 elements including silicon, germanium, tin, and lead; Group 15 elements including phosphorus, arsenic, antimony, and bismuth; and Group 16 elements including polonium.
The aforementioned metal compound is not particularly limited as long as the metal compound has the volatility

that allows it to be used in thin-film production methods such as the ALD method. Examples of ligands that may bond with the aforementioned metal atom to compose a metal compound include: halides such as chlorine, bromine, and iodine; alkanes such as methane, ethane, propane, 2-propane, and butane; monoalkylamines such as monomethylamine, monoethylamine, and monobutylamine; dialkylamines such as dimethylamine, diethylamine, ethylmethylamine, dipropylamine, diisopropylamine, dibutylamine, and di-tert-butylamine; silylamines such as trimethylsilylamine and triethylsilylamine; alkane imines such as methanimine, ethanimine, propanimine, 2-propanimine, butanimine, 2-butanimine, isobutanimine, tert-butanimine, pentanimine, and tert-pentanimine; cyclopentadienes such as cyclopentadiene, methylcyclopentadiene, ethylcyclopentadiene, propylcyclopentadiene, isopropylcyclopentadiene, butylcyclopentadiene, tert-butylcyclopentadiene, dimethylcyclopentadiene, and pentamethylcyclopentadiene; alcohols such as monoalcohols and diols; β-diketones; and β-ketoesters such as β-ketimines, methyl acetoacetate, ethyl acetoacetate, butyl acetoacetate, and 2-methoxyethyl acetoacetate. A single kind of the aforementioned compound may be bonded to the metal atom, or two or more kinds may be bonded.

Examples of metal compounds containing an alcohol and/or a β-diketone as the ligands thereof include: metal compounds represented by the following general formula (I) or (II) containing an alcohol as the ligands; metal compounds represented by the following general formula (III) or (IV) containing an alcohol and a β-diketone as the ligands; and metal compounds represented by the following general formula (V) containing a β-diketone as the ligands. Normally, the metal compound that is used contains a maximum number of ligands that can be coordinated.

[Chem. 1]

$$M\!-\!\left(OR^1\right)_m \qquad (I) \qquad\qquad MM'_a\!\left(OR^1\right)_n \qquad (II)$$

(In formulas (I) and (II), M and M' each represent a metal atom; $R^1$ represents a $C_{1-12}$ alkyl group that may be branched, that may be interrupted by an oxygen atom or a nitrogen atom, and/or that may be substituted by a halogen atom; "a" represents 1 or 2; m represents the valence of the metal atom; n represents the total valence of metal M and metal M' in the molecule; and when m or n is 2 or above, $R^1$ may be the same or different from one another.)

[Chem. 2]

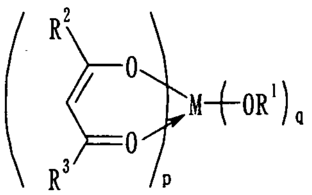
(III)

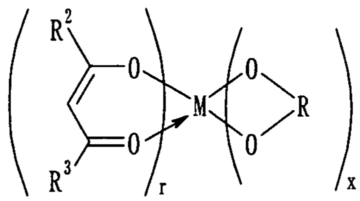
(IV)

(In formula (III), M represents a metal atom; $R^1$ represents a group as listed in general formula (I); $R^2$ and $R^3$ each represent a $C_{1-12}$ alkyl group that may be branched, that may be interrupted by an oxygen atom or a nitrogen atom, and/or that may be substituted by a halogen atom; and p and q each represent an integer of 1 or above, wherein p+q represents the valence of the metal atom. In formula (IV), M represents a metal atom; $R^2$ and$^3$ each represent a group as listed in general formula (III); R represents a $C_{2-18}$ alkanediyl group that may be branched; and r and x each represent an integer of 1 or above, wherein r+2x represents the valence of the metal atom.)

[Chem. 3]

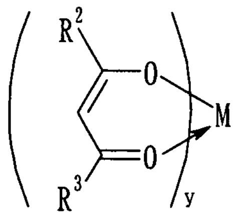

(V)

(In formula (V), M represents a metal atom; $R^2$ and $R^3$ each represent a group as listed in general formula (III); y represents the valence of the metal atom; and when y is 2 or above, $R^2$ and $R^3$ may be the same or different from one another.)

In the general formulas (I) to (III), examples of the $C_{1-12}$ alkyl group that is represented by $R^1$ and that may be branched, interrupted by an oxygen atom or a nitrogen atom, and/or substituted by a halogen atom include: methyl, ethyl, propyl, isopropyl, butyl, sec-butyl, tert-butyl, isobutyl, amyl, isoamyl, tert-amyl, hexyl, 1-ethylpentyl, cyclohexyl, 1-methylcyclohexyl, heptyl, isoheptyl, tert-heptyl, n-octyl, isooctyl, tert-octyl, 2-ethylhexyl, trifluoromethyl, perfluoropropyl, perfluorohexyl, 2-methoxyethyl, 2-ethoxyethyl, 2-butoxyethyl, 2-(2-methoxyethoxy)ethyl, 1-methoxy-1,1-dimethylmethyl, 2-methoxy-1,1-dimethylethyl, 2-ethoxy-1,1-dimethylethyl, 2-propoxy-1,1 -dimethylethyl, 2-isopropoxy-1,1-dimethylethyl, 2-butoxy-1,1-dimethylethyl, 2-sec-butoxy-1,1-dimethylethyl, 2-methoxy-1,1-diethylethyl, 2-ethoxy-1,1-diethylethyl, 2-propoxy-1,1-diethylethyl, 2-isopropoxy-1,1-diethylethyl, 2-butoxy-1,1-diethylethyl, 2-methoxy-1-ethyl-1-methylethyl, 2-propoxy-1-ethyl-1-methylethyl, 2-(2-methoxyethoxy)-1,1 -dimethylethyl, 2-propoxy-1,1-diethylethyl, and 3-methoxy-1,1-dimethylpropyl.

In the general formulas (III) to (V), examples of the $C_{1-12}$ alkyl group that is represented by $R^2$ or $R^3$ and that may be branched, interrupted by an oxygen atom or a nitrogen atom, and/or substituted by a halogen atom include the groups given as examples for $R^1$ above.

In the general formula (IV), the $C_{2-18}$ alkanediyl group represented by R is a group provided by a glycol, examples of which include 1,2-ethanediol, 1,2-propanediol, 1,3-propanediol, 1,3-butanediol, 2,4-hexanediol, 2,2-dimethyl-1,3-propanediol, 2,2-diethyl-1,3-propanediol, 2,2-diethyl-1,3-butanediol, 2-ethyl-2-butyl-1,3-propanediol, 2,4-pentanediol, 2-methyl-1,3-propanediol, and 1-methyl-2,4-pentanediol.

Examples of metal compounds containing the aforementioned dialkylamines as the ligands include the following compounds Nos. 1 to 9.

[Chem. 4]

Compound No. 1

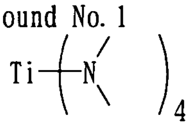

Compound No. 2

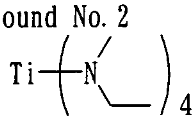

Compound No. 3

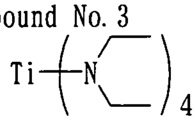

Compound No. 4

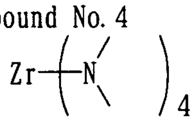

Compound No. 5

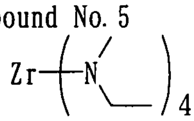

Compound No. 6

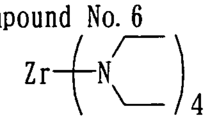

Compound No. 7

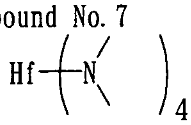

Compound No. 8

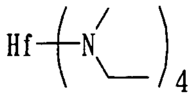

Compound No. 9

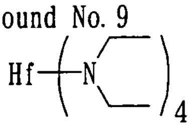

Methods of transporting and supplying the aforementioned material include: gas transporting methods in which the material is vaporized in a material container by heating and/or pressure reduction and is then supplied to the deposition reaction site with a carrier gas as necessary, such as argon, nitrogen, or helium; and liquid transporting methods in which the material is first transported to a vaporization chamber in the state of a liquid or solution and is then vaporized

in the vaporization chamber by heating and/or pressure reduction and supplied to the deposition reaction site. In the gas transporting method, the metal compound itself serves as the material, whereas in the liquid transporting method, the metal compound itself or a solution prepared by dissolving the metal compound in an organic solvent serves as the material.

Meanwhile, methods of producing multi-component thin films include: methods of vaporizing and supplying the materials separately and independently for each component (also referred to hereinafter as "single source methods"); and methods of vaporizing and supplying a mixed material prepared by mixing the materials for the multiple components in advance at a desired composition (also referred to hereinafter as "cocktail source methods"). In the cocktail source method, either a mixture consisting only of the multiple types of metal compounds or a mixed solution prepared by adding an organic solvent to the mixture serves as the material.

As regards the metal compounds (precursors) to be used in the production of multi-component thin films, it is preferable to use compounds that exhibit a similar reaction or decomposition behavior when the precursors transform into the thin film composition in case of the single source method. In case of the ALD method, it is preferable to use compounds having reactivity with the molecular-level layer that has been formed. In case of the cocktail source method, it is preferable to use compounds that do not cause degeneration by chemical reaction when mixed together, in addition to having a similar behavior when transforming into the thin film composition.

As for the organic solvent to be used in the aforementioned material, generally known organic solvents that do not react with the metal compound can be used without particular limitation. Examples of such organic solvents include: alcohols such as methanol, ethanol, 2-propanol, and n-butanol; acetic esters such as ethyl acetate, butyl acetate, and methoxyethyl acetate; ether alcohols such as ethylene glycol monomethyl ether, ethylene glycol monoethyl ether, and ethylene glycol monobutyl ether; ethers such as tetrahydrofuran, tetrahydropyran, morpholine, ethylene glycol dimethyl ether, diethylene glycol dimethyl ether, triethylene glycol dimethyl ether, dibutyl ether, and dioxane; ketones such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons such as hexane, cyclohexane, methylcyclohexane, dimethylcyclohexane, ethylcyclohexane, heptane, octane, toluene, and xylene; cyano group-containing hydrocarbons such as acetonitrile, 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; aliphatic polyamines such as diethylamine, triethylamine, dibutylamine, tributylamine, ethylenediamine, N,N'-tetramethylethylenediamine, N,N'-tetramethylpropylenediamine, diethylenetriamine, triethylenetetramine, tetraethylenepentamine, pentaethylenehexamine, 1,1,4,7,7-pentamethyldiethylenetriamine, and 1,1,4,7,10,10-hexamethyltriethylenetetramine; nitrogen-containing cyclic compounds such as pyrrole, imidazole, pyrazole, pyridine, lutidine, pyrazine, pyrimidine, pyrrolidone, imidazolidine, pyrazolidine, piperidine, piperazine, and morpholine; and compounds having cyano groups. In relation to properties such as the ability of dissolving the solute, the temperature used, the boiling point, and the flash point, the aforementioned organic solvents may be used singly or as a mixed solvent containing two or more kinds of solvents. In cases of using the organic solvent(s), the total amount of the metal compound component is preferably 0.01 to 2.0 mol/L, more preferably 0.05 to 1.0 mol/L, in the organic solvent(s).

The aforementioned material may also contain a nucleophilic reagent as necessary to impart stability to the metal compound. Examples of the nucleophilic reagent include: ethylene glycol ethers such as glyme, diglyme, triglyme, and tetraglyme; crown ethers such as 18-crown-6, dicyclohexyl-18-crown-6, 24-crown-8, dicyclohexyl-24-crown-8, and dibenzo-24-crown-8; polyamines such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethylene amine; cyclic polyamines such as cyclam and cyclen; and heterocycle compounds such as pyridine, pyrrolidine, piperidine, morpholine, N-methylpyrrolidine, N-methylpiperidine, N-methyl morpholine, tetrahydrofuran, tetrahydropyran, 1,4-dioxane, oxazole, thiazole, and oxathiolane. The usage amount of the nucleophilic reagent serving as a stabilizer is generally from 0.05 mol to 10 mol, preferably from 0.1 to 5 mol, with respect to 1 mol of the metal compound.

The aforementioned material should contain the smallest amount possible of metal impurities, halogen impurities such as chlorine, and organic impurities, other than the components constituting the material. The amount of metal impurities is preferably 100 ppb or less, more preferably 10 ppb or less, for each metal element. The total amount of metal impurities is preferably 1 ppm or less, more preferably 100 ppb or less. The amount of halogen impurities is preferably 100 ppm or less, more preferably 10 ppm or less, even more preferably 1 ppm or less. The total amount of organic impurities is preferably 500 ppm or less, more preferably 50 ppm or less, even more preferably 10 ppm or less. Meanwhile, water gives rise to particles, so it is preferable to remove water from the metal compound, the organic solvents, and the nucleophilic reagents in advance of using them to the furthest extent possible to reduce the amount of water contained in those compounds/agents. The amount of water is preferably 10 ppm or less, more preferably 1 ppm or less.

To inhibit or prevent the produced thin film from being contaminated by particles, it is preferable that the aforementioned material contains at most 100 particles larger than 0.3 μm, more preferably at most 1000 particles larger

than 0.2 μm per 1 mL of the liquid phase, and even more preferably at most 100 particles larger than 0.2 μm per 1 mL of the liquid phase, the number of particles being found by subjecting the liquid phase to particle measurement using a light-scattering liquid-borne particle detector.

Other than water vapor, examples of reactive gases that may be used in the CVD method or the ALD method, in which the process of the present invention has been incorporated, include oxidizing gases, such as oxygen, singlet oxygen, ozone, carbon dioxide, nitrogen dioxide, nitric oxide, hydrogen peroxide, formic acid, acetic acid, acetic anhydride, and peracetic acid, which are examples that produce oxides.

Examples of conditions for producing metallic thin films by the CVD method or the ALD method, in which the process of the present invention has been incorporated, include reaction temperature (substrate temperature), reaction pressure, and deposition rate. The reaction temperature is preferably at least 150°C, which is the temperature at which the metal compound reacts sufficiently, and more preferably from 250°C to 450°C. The reaction pressure is preferably from atmospheric pressure to 10 Pa, and in cases of using plasmas, the reaction pressure is preferably from 2000 Pa to 10 Pa. The deposition rate can be controlled by adjusting the conditions for supplying the material (e.g., vaporization temperature, vaporization pressure), the reaction temperature, and/or the reaction pressure. High deposition, rates may impair the properties of the thin film produced, whereas low deposition rates may cause problems in productivity; so the deposition rate is preferably from 0.5 to 5000 nm/minute, more preferably from 1 to 1000nm/minute. For the ALD method, the number of cycles may be controlled to achieve the desired film thickness.

Further, to achieve even better electrical properties, annealing may be performed in an inert atmosphere, an oxidizing atmosphere, or a reducing atmosphere, after the thin-film deposition. A reflow step may be provided for cases where steps need to be filled in. The annealing and reflow temperatures are within temperature ranges acceptable for the usage, which are generally from 300 to 1200°C, preferably from 400 to 600°C.

Examples of thin films that are produced by the thin-film production method, such as the CVD method or the ALD method including the process of the present invention, include metal-oxide thin films, metal-oxide-nitride thin films, and glass. Composition examples of metal-oxide thin films that may be produced include: silicon oxide; titanium oxide; zirconium oxide; hafnium oxide; bismuth-titanium complex oxide; bismuth/rare-earth element/titanium complex oxide; silicon-titanium complex oxide; silicon-zirconium complex oxide; silicon-hafnium complex oxide; hafnium-aluminum complex oxide; hafnium/rare-earth element complex oxide; silicon-bismuth-titanium complex oxide; silicon-hafnium-aluminum complex oxide; silicon/hafnium/rare-earth element complex oxide; titanium-zirconium-lead complex oxide; titanium-lead complex oxide; strontium-titanium complex oxide; barium-titanium complex oxide; and barium-strontium-titanium complex oxide. Composition examples of metal-nitride thin films include: silicon nitride; titanium nitride; zirconium nitride; hafnium nitride; titanium-aluminum complex nitride film; silicon-hafnium complex oxide nitride (HfSiON); and titanium complex oxide nitride. These thin films may be used for electronic components, such as high-dielectric capacitor films, gate insulating films, gate films, electrode films, barrier films, ferroelectric capacitor films, and capacitor films, as well as for optical glass components, such as optical fibers, light guides, optical amplifiers, and optical switches.

## Examples

The present invention will be described in further detail below according to Examples, Comparative Examples, and Evaluation Examples. The present invention, however, is in no way limited by the following Examples etc.

### Example 1: Dehydration by 1-Butanol

Commercially-available 1-butanol (water content at the azeotropic composition: 43% by mass) was used as the purge solvent, and dehydration was performed using the device illustrated in Fig. 1 according to the following conditions.

Line:

Five VCR (registered trademark) metal, gasket-type face-seal fittings (product of Swagelok; total length: 306.8 mm; inner diameter: 4.6 mm) were connected together.

Steps:

(1) Supply ultrapure water to the line.
(2) Purge with argon for 5 seconds.
(3) Keep the line temperature at 100°C for 30 minutes to vaporize the remaining water.

(4) Supply 1-butanol gas, which has been vaporized while bubbling argon at 0.5 slm, at a line temperature of 100°C for 5 minutes to remove the remaining water.
(5) Purge with argon for 30 seconds to remove the purge solvent gas.
(6) While reducing the pressure with a vacuum pump, monitor the pressure for 10 minutes using a Pirani gauge.

Example 2: Dehydration by 1-Pentanol

Dehydration was performed according to the same conditions as in Example 1, except that the purge solvent was changed to 1-pentanol (water content at the azeotropic composition: 54% by mass).

Example 3: Dehydration by 1-Pentanol/Xylene Mixed Solvent

Dehydration was performed according to the same conditions as in Example 1, except that the purge solvent was changed to a mixed solvent composed of 1:1 (molar ratio) of 1-pentanol and xylene. Note that in the mixed solvent, the water content at the azeotropic composition was 14% by mass, and the alcoholic solvent content at the azeotropic composition with the alcoholic solvent was 27% by mass.

Example 4: Dehydration by Isopropanol/Toluene Mixed Solvent

Dehydration was performed according to the same conditions as in Example 1, except that the purge solvent was changed to a mixed solvent composed of 1:1 (molar ratio) of isopropanol and toluene. Note that in the mixed solvent, the water content at the azeotropic composition was 5.2% by mass, and the alcoholic solvent content at the azeotropic composition with the alcoholic solvent was 42% by mass.

Example 5: Dehydration by Isopropanol

Dehydration was performed according to the same conditions as in Example 1, except that the purge solvent was changed to isopropanol (water content at the azeotropic composition: 12% by mass).

Example 6: Dehydration by Isopropyl Ether

Dehydration was performed according to the same conditions as in Example 1, except that the purge solvent was changed to isopropyl ether (water content at the azeotropic composition: 4.5% by mass).

Evaluation Example:

The time-varying pressure during the period of 0 to 10 minutes was measured using a Pirani gauge in the aforementioned step (6) of the Example. From the following equation:

$$\text{Degree of Vacuum Reached} = 100 \times (P_A - P_X)/(P_A - P_B),$$

the degree of vacuum reached was calculated by substituting the following values in the equation:

$P_B$: Pressure for when no water was supplied (Blank);
$P_A$: Pressure for when only argon was supplied after supplying water;
$P_X$: Pressure for when the purge solvent gas was supplied after supplying water.

The average degree of vacuum reached was calculated from the values obtained during the 10 minutes from the pressure-reduction start point, and compared. Table 1 shows the results of the absolute value of the pressure found after 10 minutes and the average degree of vacuum reached.

[Table 1]

| | Purge solvent | Pressure after 10 minutes (Pa) | Average degree of vacuum reached (%) |
|---|---|---|---|
| Example 1 | 1-Butanol | 1.398 | 58 |
| Example 2 | 1-Pentanol | 1.389 | 73 |
| Example 3 | 1-Pentanol/ xylene | 1.385 | 78 |
| Example 4 | Isopropanol/ toluene | 1.393 | 66 |
| Example 5 | Isopropanol | 1.400 | 32 |
| Example 6 | Isopropyl ether | 1.412 | 25 |
| - | Argon only | 1.430 | - |
| - | Blank | 1.376 | - |

It was verified from Table 1 that, in cases where the purge solvent gases were supplied, the pressure after 10 minutes was lower and the average degree of vacuum reached was higher, and thus the removal of water from the system was promoted, compared to where only argon was supplied. Particularly, the average degree of vacuum reached was high for Examples 1 and 2, in which the purge solvents used were 1-butanol and 1-pentanol having a water content at the azeotropic composition of at least 20% by mass, and Examples 3 and 4, in which the purge solvents used were a 1-pentanol/xylene mixed solvent and an isopropanol/toluene mixed solvent having an alcoholic-solvent content at the azeotropic composition with the alcoholic solvent of at least 20% by mass, showing that efficient removal of water from the system was possible.

**Claims**

**1.** A process for removing residual water molecules, the process being used in a metallic thin film production method of forming a metallic thin film on a substrate, the process comprising:

removing residual water molecules using a gas generated by vaporizing a purge solvent.

**2.** The process according to claim 1, wherein the purge solvent is an organic solvent or an organic solvent composition having a water content at the azeotropic composition of at least 20% by mass.

**3.** The process according to claim 1 or 2, wherein the purge solvent is an alcoholic solvent or an organic solvent composition containing an alcoholic solvent.

**4.** The process according to any one of claims 1 to 3, wherein the purge solvent is an alcoholic solvent or an organic solvent composition comprising an alcoholic solvent and a hydrocarbonic solvent.

**5.** The process according to claim 3 or 4, wherein the alcoholic solvent is 1-butanol or 1-pentanol.

**6.** The process according to claim 4, wherein the purge solvent is said organic solvent composition comprising an alcoholic solvent and a hydrocarbonic solvent; the alcoholic solvent is 1-butanol or 1-pentanol; and the hydrocarbonic solvent is toluene or xylene.

**7.** A purge solvent, which is an organic solvent or an organic solvent composition having a water content at the azeotropic composition of at least 20% by mass.

**8.** The purge solvent according to claim 7, which is an alcoholic solvent or an organic solvent composition containing an alcoholic solvent.

**9.** The purge solvent according to claim 7 or 8, wherein the purge solvent is an alcoholic solvent or an organic solvent composition comprising an alcoholic solvent and a hydrocarbonic solvent.

**10.** The purge solvent according to claim 8 or 9, wherein the alcoholic solvent is 1-butanol or 1-pentanol.

**11.** The purge solvent according to claim 9, wherein the purge solvent is said organic solvent composition comprising an alcoholic solvent and a hydrocarbonic solvent; the alcoholic solvent is 1-butanol or 1-pentanol; and the hydrocarbonic solvent is toluene or xylene.

[Fig. 1]

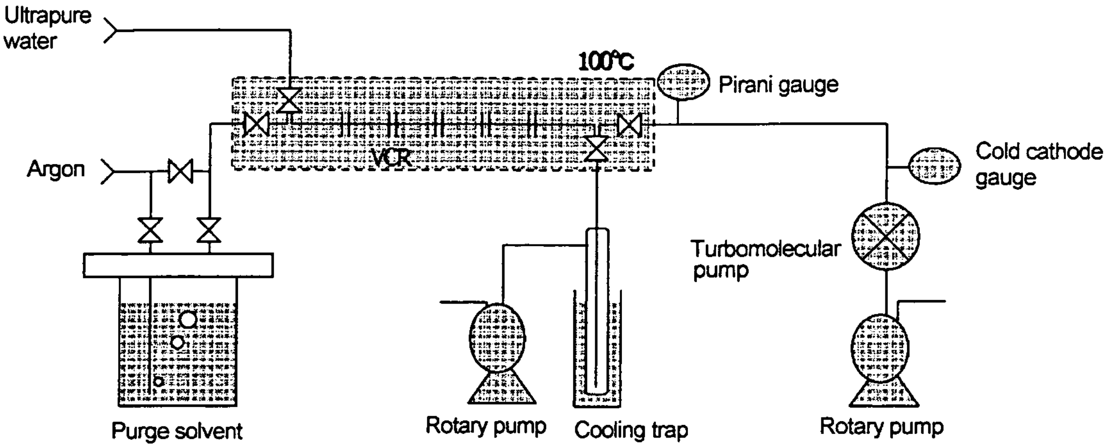
Ultrapure water
100°C
Pirani gauge
Argon
VCR
Cold cathode gauge
Turbomolecular pump
Purge solvent
Rotary pump
Cooling trap
Rotary pump

**INTERNATIONAL SEARCH REPORT**

International application No.
PCT/JP2010/052199

A. CLASSIFICATION OF SUBJECT MATTER
*C23C16/44*(2006.01)i, *C23C16/52*(2006.01)i, *H01L21/285*(2006.01)i

According to International Patent Classification (IPC) or to both national classification and IPC

B. FIELDS SEARCHED

Minimum documentation searched (classification system followed by classification symbols)
C23C16/00-16/56, H01L21/285

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2-166729 A (Matsushita Electric Industrial Co., Ltd.), 27 June 1990 (27.06.1990), claims; examples (Family: none) | 1,3,4 |
| X | JP 2006-295194 A (Samsung Electronics Co., Ltd.), 26 October 2006 (26.10.2006), claims; Best Mode for carrying out the Invention & US 2006/0231125 A1 & DE 102006017056 A & KR 10-2006-0108429 A | 1-5,7-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>19 April, 2010 (19.04.10) | Date of mailing of the international search report<br>27 April, 2010 (27.04.10) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2010/052199

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-108199 A (Tri-Chemical Lab., Inc.), 20 April 2001 (20.04.2001), claims; Mode for carrying out the Invention (Family: none) | 1-11 |
| A | JP 2003-273030 A (Kabushiki Kaisha Watanabe Shoko), 26 September 2003 (26.09.2003), entire text & US 2006/0270222 A1 & EP 1492159 A1 & WO 2003/079421 A1 | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2002042165 A1
- JP 2004023043 A
- US 2006046421 A1
- JP 2006182709 A
- US 2004248397 A1